Europäisches Patentamt

European Patent Office

Office européen des brevets

(19)

(11) Numéro de publication: **0 017 541**
**B1**

(12) **FASCICULE DE BREVET EUROPEEN**

(45) Date de publication du fascicule du brevet: **13.04.83**

(51) Int. Cl.³: **H 03 H 15/02**

(21) Numéro de dépôt: **80400364.8**

(22) Date de dépôt: **18.03.80**

(54) **Filtre transversal à transfert de charges électriques.**

(30) Priorité: **06.04.79 FR 7908789**

(43) Date de publication de la demande:
**15.10.80 Bulletin 80/21**

(45) Mention de la délivrance du brevet:
**13.04.83 Bulletin 83/15**

(84) Etats contractants désignés:
**DE GB NL**

(56) Documents cités:
**FR - A - 2 373 125**
**FR - A - 2 389 899**
**FR - A - 2 397 756**
**FR - A - 2 414 823**

**IEEE Transactions on Electron Devices, ED 23**
**No. 2, Fév. 1976, pp 133 à 142.**

(73) Titulaire: **THOMSON-CSF**
**173, Boulevard Haussmann**
**F-75379 Paris Cedex 08 (FR)**

(72) Inventeur: **Berger, Jean-Luc**
**"THOMSON-CSF" SCPI - 173, Bld Haussmann**
**F-75360 Paris Cedex 08 (FR)**

(74) Mandataire: **Benichou, Robert et al,**
**THOMSON-CSF SCPI 173 bld Haussmann**
**F-75379 Paris Cedex 08 (FR)**

Courier Press, Leamington Spa, England.

**0 017 541**

### Filtre transversal à transfert de charges électriques

La présente invention concerne un filtre transversal à transfert de charges électriques à électrodes coupées.

On rappelle qu'un filtre transversal à électrodes coupées est généralement constitué par un substrat semi-conducteur recouvert d'une couche isolante sur laquelle alternent des électrodes de transfert et des électrodes de stockage des charges, recevant périodiquement des potentiels donnés. Ces électrodes sont disposées parallèlement les unes aux autres et transversalement par rapport à la direction de transfert des charges. Les électrodes de stockage sont coupées transversalement, généralement en deux parties, et les quantités de charges se trouvant sous les deux parties de chaque électrode de stockage sont lues différentiellement afin de réaliser une pondération du signal à filtrer.

L'article de Richard D. Baertsch et al, intitulé "The design and operation of practical charge-transfer transversal filters", et paru dans la Revue IEEE Transactions on Electron Devices, volume ED-23, numéro 2, de Février 1976, pages 133 à 142, traite des filtres transversaux à électrodes coupées et des problèmes qu'ils posent; parmi ces problème, on peut citer:

— la nécessité de réaliser un lecture des charges différentielle pour obtenir des coefficients de pondération positifs et négatifs; cette lecture différentielle est classiquement réalisée à l'aide d'un amplificateur différentiel extérieur, qui a pour inconvénient son encombrement, ou à l'aide d'un amplificateur différentiel intégré sur le même substrat que le filtre lui-même et constitué essentiellement de transistors MOS, qui a pour inconvénients sa grande consommation bien supérieure à celle des dispositifs à transfert de charges et les non-linéarités susceptibles d'être introduites par les transistors MOS;

— le mode commun élevé lors de l'élaboration des coefficients de pondération proches de zéro, ce qui tend à provoquer la saturation de l'amplificateur différentiel et ce qui en tous cas diminue son rapport signal sur bruit car le signal différentiel dininue sans que la capacité des électrodes de stockage diminue;

— la perturbation de la lecture des charges se trouvant sous les électrodes de stockage par les signaux de commande appliqués aux différentes électrodes;

— le nombre élevé de signaux de commande.

La présente invention concerne un filtre transversal à transfert de charges électriques dont une électrode de stockage sur deux est coupée transversalement en deux parties, dont l'une est connectée à un potentiel sensiblement constant ($V_p$).

Selon l'invention, ce filtre comporte des moyens de lecture, reliés en un point P à l'autre partie de chaque électrode de stockage coupée. Ces moyens lisent négativement les charges quittant une électrode de stockage coupée, dite négative, et positivement les charges arrivant sous l'électrode de stockage coupée suivante, dite positive. Chaque coefficient de pondération est déterminé par l'utilisation de quatre électrodes de stockage alternativement coupées et non coupées La différence de longueurs entre les parties de deux électrodes de stockage coupées sous lesquelles les charges sont lues, positivement et négativement détermine le coefficient.

Les couples électrode de transfert-électrode de stockage coupée reçoivent ledit potentiel sensiblement constant $V_P$ et les couples électrode de transfert-électrode de stockage entière reçoivent un signal périodique, de périodie égale à la moitié de la période d'injection des charges dans le filtre, qui assure, à un instant donné, la présence de charges sous une électrode de stockage coupée sur deux du filtre.

Le filtre transversal à électrodes coupée selon l'invention présente de nombreux avantages parmi lesquels on peut citer;

— la lecture différentielle des charges réalisée directement sans amplificateur différentiel;

— la réduction du mode commun à la largeur du canal du dispositif à transfert de charges minimale pour obtenir un transfert de charges dans de bonnes conditions;

— la suppression de la perturbation approtée à la lecture des charges se trouvant sous les électrodes de stockage par les signaux de commande appliqués au différentes électrodes;

— le nombre de signaux de commande réduit à trois.

D'autres objets, caractéristiques et résultats de l'invention ressortiront de la description suivante, donnée à titre d'exemple non limitatif et illustrée par les figures annexées qui représentent:

la figure 1, un schéma illustrant le fonctionnement du filtre selon l'invention;

la figure 2, un mode de réalisation du filtre selon l'invention;

les figures 3a, b, c, des diagrammes de signaux susceptibles d'être appliqués au filtre selon l'invention;

les figures 4a à 4f, des schémas illustrant le fonctionnement du filtre selon l'invention.

2

Sur les différentes figures, les mêmes repères désignent les mêmes éléments, mais, pour des raisons de clarté, les cotes et proportions des différents éléments n'ont pas été respectées.

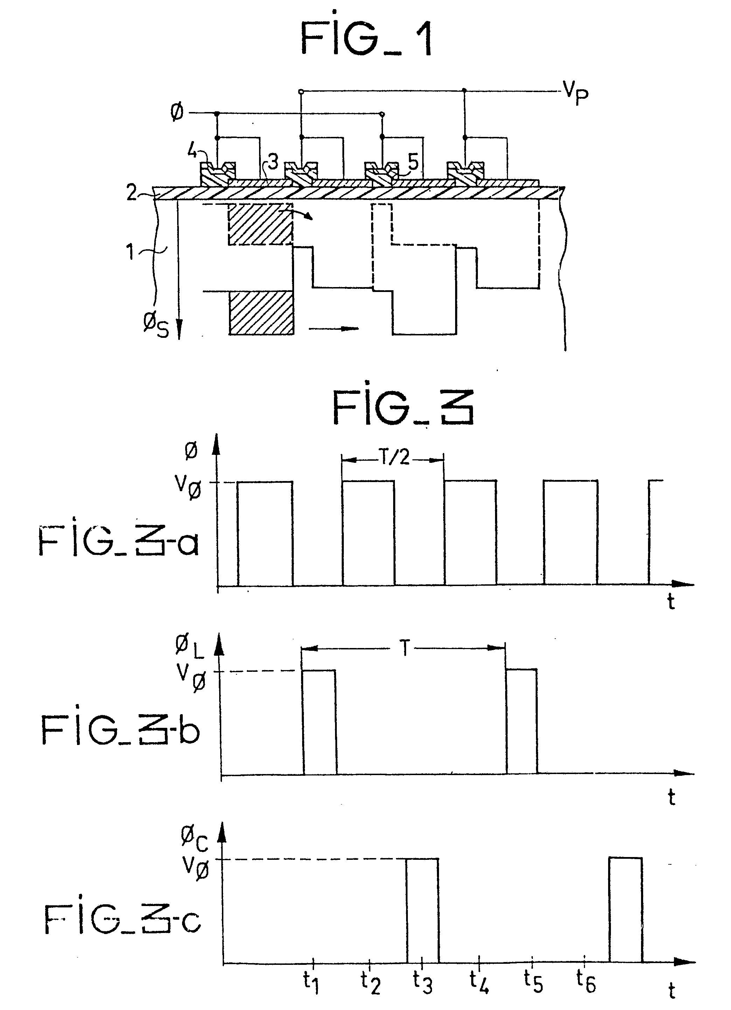

La Figure 1 représente un schéma illustrant le fonctionnement du filtre selon l'invention.

Le filtre selon l'invention qui est représenté, vu en coupe transversale, selon la direction de propagation des charges indiquée par une flèche, comporte un substrat semi-conducteur 1, en silicium de type P dans l'exemple, recouvert d'une couche isolante 2, en oxyde de silicium dans l'exemple. Sur cette couche isolante 2, sont déposées des électrodes de stockage des charges 3, sensiblement normalement à la direction de propagation des charges. Des électrodes de transfert des charges 4 alternent avec les électrodes de stockage. Les électrodes de transfert 4 sont déposées sur une surépaisseur d'isolant 5.

Ainsi qu'il est connu, cette disposition a une double fonction, d'une part, assurer la continuité des potentiels créés dans le semi-conducteur 1, et d'autre part, imposer un sens de transfert unique pour les porteurs de charges.

Cette structure comportant un surépaisseur d'isolant peut être remplacée par un surdopage du substrat, par implantations d'ions, assurant les mêmes fonctions.

Le filtre selon l'invention fonctionne en monophasé. Une électrode de stockage sur deux est coupée en deux parties. Les couples électrode de transfert-électrode de stockage entières reçoivent un signal périodique $\phi$. Les couples électrode de transfert électrode de stockage coupée reçoivent un potentiel constant $V_P$.

On a également représenté sur la figure 1, le potentiel de surface $\phi_s$ sous les couples électrode de transfert-électrode de stockage. Les marches de potentiel de surface sous les couples d'électrodes commandées par le signal périodique $\phi$ sont tantôt supérieures à celles qui se trouvent sous les couples d'électrodes commandées par le potentiel constant $V_P$ (dans ce cas, les charges se trouvent sous les électrodes de stockage commandées par $\phi$) et tantôt inférieures et représentées en trait discontinu sur la figure (dans ce cas, les charges sont transférées sous les électrodes de stockage commandées par $V_P$).

Les courbes représentant les variations du potentiel de surface sous les électrodes de transfert et de stockage en fonction de la tension appliquée à ces électrodes doivent être sensiblement parallèles pour que la capacité de stockage soit constante pour les couples d'électrodes commandées par $\phi$ et par $V_P$. Il est possible d'ajuster par implantation les seuils sous les électrodes de transfert et de stockage.

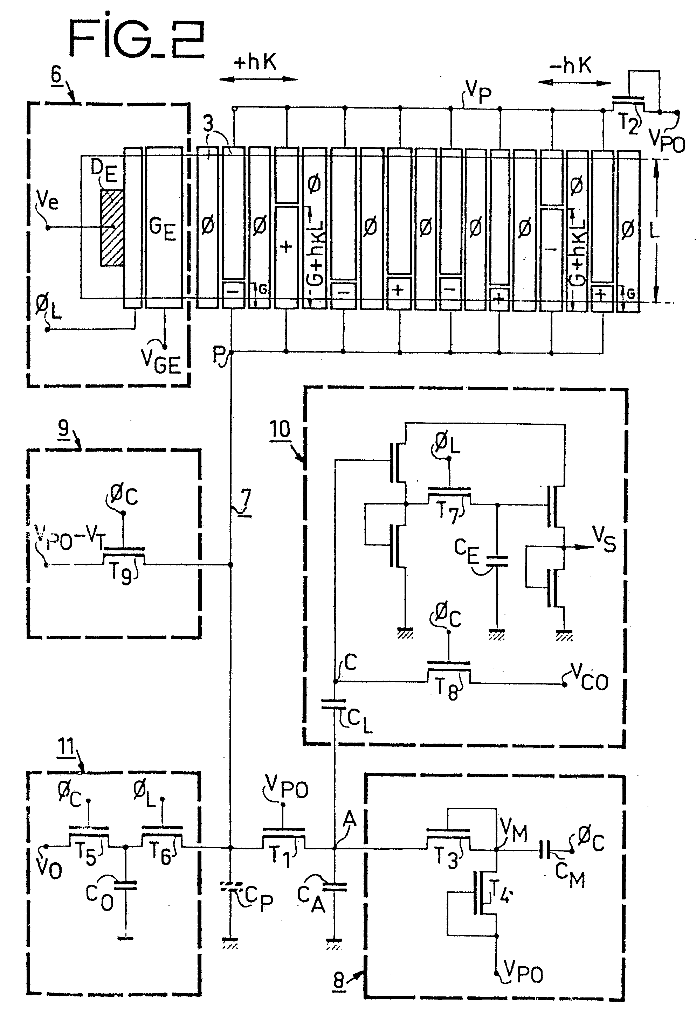

La figure 2 représente un mode de réalisation du filtre selon l'invention. Sur la figure 2, les électrodes de transfert ne sont pas représentées et seules les électrodes de stockage, alternativement entières et commandées par $\phi$ et coupées en deux parties et commandées par $V_P$, sont représentées vues de dessus.

Le filtre selon l'invention comporte un dispositif d'injection des charges classiques 6, constitué d'une diode d'entrée $D_E$ qui reçoit le signal d'entrée à filtrer $V_e$, suivie d'une grille d'échantillonnage commandée par un signal périodique $\phi_L$ et d'une grille de stockage $G_E$ maintenue à une tension fixe $V_{GE}$.

La fréquence du signal périodique $\phi_L$ appliqué à la grille d'échantillonnage est égale à la moitié de celle du signal périodique $\phi$ qui assure le transfert des charges dans le filtre. L position des signaux $\phi$ et $\phi_L$ l'un par rapport à l'autre est telle que les charges signal ne sont présentes à un instant donné que sous une électrode de stockage coupée sur deux du filtre.

Les coefficients de pondération du filtre sont élaborés par des moyens de lecture 7 reliés en un point P à une partie de chaque électrode de stockage coupée et qui imposent le potentiel constant $V_P$. Les parties des électrodes de stockage coupées sous lesquelles des charges ne sont pas lues sont également portées au potentiel constant $V_P$, dans l'exemple, par l'intermédiaire d'un transistor MOS $T_2$, relié à un potentiel constant $V_{PO}$ qui est tel que $V_P = V_{PO} - V_T$, $V_T$ étant la tension seuil du transistor MOS $T_2$ dont la grille est également reliée au potentiel constant $V_{PO}$.

Les moyens de lecture 7 lisent négativement les charges quittant une électrode de stockage coupée, dite négative, et positivement les charges arrivant sous l'électrode de stockage coupée suivante, dite positive. Deux électrodes de pondération coupées sont donc nécessaire pour l'élaboration d'un coefficient de pondération et le filtre selon l'invention comporte donc un nombre d'étages double du nombre de coefficients.

Pour élaborer un coefficient de pondération de valeur $+h_K$, il faut donner une longueur G à la partie d'une électrode de stockage négative, sous laquelle les charges sont lues (elle est repérée par le signe — sur la figure), et il faut donner une longueur $G + h_K$. L à la partie de l'électrode de stockage positive suivante sous laquelle les charges sont lues (elle est repérée par le signe+sur la figure) G étant la largeur minimale du canal CCD permettant d'obtenir un transfert de charges dans de bonnes conditions et L étant la largueur du canal CCD.

Pour obtenir un coefficient de pondération de valeur $-h_K$, ul faut réciproquement donner une longueur $G + h_K$. L à une électrode repérée par le signe—sur la figure 2 et sur une longueur G à l'électrode repérée par le signe+suivante.

Le filtre selon l'invention permet donc de réduire le mode commun à la largeur du canal du dispositif à transfert de charges minimale pour obtenir un transfert de charges dans de bonnes conditions, ce qui améliore la précision de lecture des petits coefficients de pondération.

Dans le mode de réalisation, représenté sur la figure 2, les moyens de lecture 7 comportent un premier transistor MOS $T_1$ connecté entre le point P et un point A. Le transistor $T_1$ reçoit sur sa grille un

3

**0017541**

potentiel constant $V_{PO}$ tel que le potentiel au point P égale: $V_P = V_{PO} - V_T$, $V_T$ étant la tension seuil du transistor $T_1$. Entre le point A et la masse est reliée une capacité de lecture $C_A$.

Au point A se trouve connecté un circuit 8 qui permet la précharge de la capacité de lecture $C_A$ au potentiel $V_{AO}$ et l'évacuation des charges qui, dans le transistor $T_1$, représentent les coefficients de pondération élaborés. Ce circuit 8 comporte un transistor MOS $T_3$ entre le point A et un point $V_M$, la grille de $T_3$ étant réunie à $V_M$. Au point $V_M$, sont reliés une capacité $C_M$ recevant un signal périodique $\phi_C$ et un transistor MOS $T_4$ qui reçoit le potentiel constant $V_{PO}$, la grille de $T_4$ étant également reliée à $V_{PO}$.

Au point P, est connecté un transistor MOS $T_9$ qui effectue la pré-charge du point P au potentiel $V_{PO} - V_T$ au moment de l'arrivée des charges signal sous les électrodes de stockage négatives. Le transistor $T_9$ fonctionne en triode, il est relié au potentiel $V_{PO} - V_T$ et reçoit sur sa grille le signal périodique $\phi_C$.

Au point A est également connecté un circuit de sortie 10 qui délivre la tension de sortie du filtre $V_S$. Le circuit 10 comporte une capacité de liaison $C_L$ entre le point A et un point C. Un transistor MOS $T_8$ est connecté entre le point C et un potentiel constant $V_{CO}$. Au point C, est également connecté un premier étage suiveur, suivi par un transistor MOS $T_7$, commandé par le signal périodique $\phi_L$, suivi par une capacité $C_E$ entre l'une des bornes de $T_7$ et la masse, et suivi enfin par un deuxième étage suiveur qui délivre le signal de sortie du filtre $V_S$.

Dans le cas où la somme des coefficients de pondération du filtre est négative, un circuit 11 est connecté au point P. Ce circuit 11 est composé de deux transistors MOS $T_6$ et $T_5$ en série, recevant sur leurs grilles les signaux périodiques $\phi_L$ et $\phi_C$. L'une des bornes de $T_5$ est portée à un potentiel constant $V_O$. Une capacité $C_O$ est connectée entre le point commun de $T_5$ et $T_6$ et la masse.

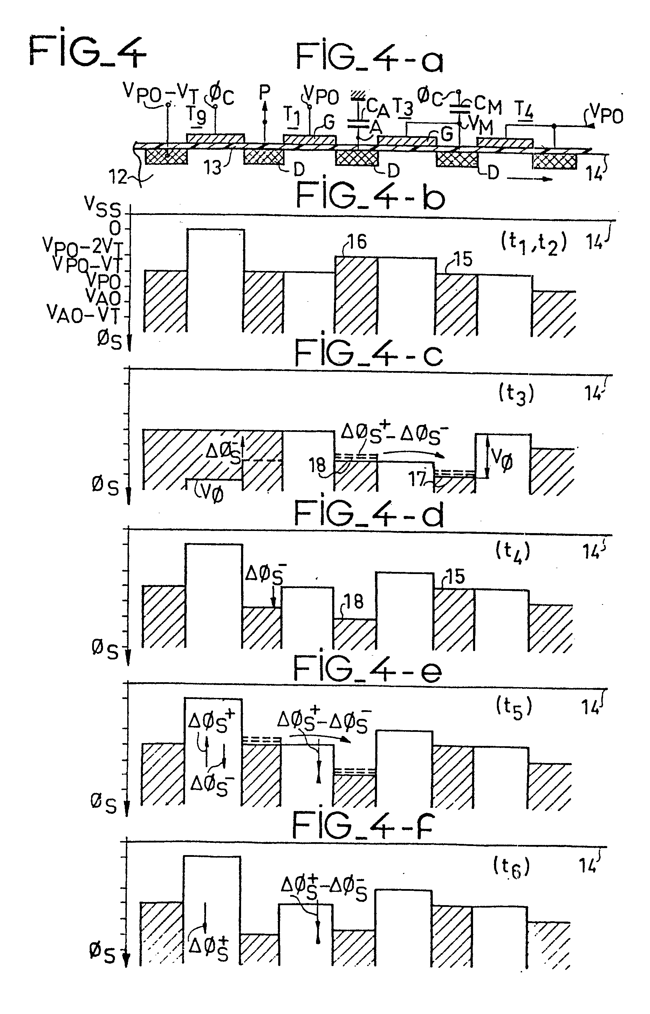

Les figures 4a à 4f illustrent le fonctionnement du filtre selon l'invention.

Sur la figure 4a, on a représenté, vu en coupe transversale selon le sens de transfert des charges indiqué par une flèche, un substrat semi-conducteur 12, recouvert d'une couche isolante 13, dans lequel sont notamment intégrés les quatre transistors MOS $T_9$, $T_1$, $T_3$, $T_4$ des moyens de lecture 7 représentés sur la figure 2. L'ensemble du dispositif à transfert de charges et des moyens de lecture 7 est généralement intégré sur le même substrat semi-conducteur.

Les transistors $T_9$, $T_1$, $T_3$, $T_4$ sont constitués de deux diodes D implantées dans le substrat 12 et d'une grille de commande G déposée sur la couche isolante 13 entre les deux diodes.

Les figures 4b à 4f représentent l'évolution du potentiel de surface $\phi_S$ sous les transistors $T_9$, $T_1$, $T_3$, $T_4$ au cours du temps. On a seulement représenté sur ces figures l'interface 14 du substrat 12 et de la couche isolante 13.

Sur ces figures, les zones hachurées représentent les porteurs minoritaires.

Les figures 3a, b, c représentent des diagrammes de signaux $\phi$, $\phi_L$, $\phi_C$ susceptibles d'être appliqués au filtre selon l'invention.

Le signal périodique $\phi$ a une période

$$\frac{T}{2}$$

qui est la moitié de celle des signaux périodiques $\phi_L$ et $\phi_C$. Ces signaux varient entre un niveau bas et un niveau haut $V_\phi$.

Les signaux $\phi_L$ et $\phi_C$ sont de préférence identique mais déphasés. Les signaux $\phi_L$ et $\phi_C$ se trouvent au niveau haut alors que le signal $\phi$ se trouve au niveau bas. Les signaux $\phi_L$ et $\phi_C$ sont décalés de

$$\frac{T}{2}$$

Le fonctionnement du filtre selon l'invention représenté sur la figure 2 est le suivant:
— au temps $t_1$, $\phi_L$ est au niveau haut et égale $V_\phi$. Un paquet de charges est injecté sous la grille d'entrée $G_E$, établissant un potentiel de surface sous $G_E$ égal à la tension signal $V_e$. Le signal $\phi_C$ est au niveau bas, le point $V_M$ est donc au potentiel $V_{PO} - V_T$ par le transistor $T_4$. Le point A est porté au potentiel $V_{PO} - 2V_T$ par le transistor $T_3$. Le niveau du potentiel de surface aux points $V_M$ et A, aux temps $t_1$ et $t_2$, est représenté par les lignes 15 et 16 sur la figure 4b.
— au temps $t_2$, le signal $\phi$ passe au niveau haut. Le paquet de charges injecté sous la grille $G_E$ au temps $t_1$ est donc transféré sous la première électrode de stockage entière commandée par le signal $\phi$. Le potentiel de surface aux points A et $V_M$ est le même qu'au temps $t_1$.
— au temps $t_3$, le signal $\phi$ est au niveau bas. Les charges sont donc transférées sous la première électrode de stockage coupée qui doit lire les charges négativement, à leur départ de cette électrode. Au temps $t_3$, le signal $\phi_C$ est au niveau haut. Le passage de $\phi_C$ au niveau haut rend conducteur le transistor $T_9$ qui fonctionne en triode et impose le potentiel $V_{PO} - V_T$ au point P.

Le passage de $\phi_C$ au niveau haut porte le potentiel de surface au point $V_M$ à $V_{PO} - V_T + V_\phi$ (ligne 17

4

**0017541**

sur la figure 4c). Le potentiel de surface au point A passe donc par le transistor $T_3$ au potentiel $V_{AO}$ tel que:

$$V_{AO}=V_{PO}-2V_T+V_\phi$$

(ligne 18 sur la figure 4c) qui est très supérieur à $V_{PO}-V_T$.

Le potentiel $V_{AO}$ étant supérieur à $V_{PO}-V_T$, le transistor $T_1$ est alors polarisé en saturation. Si le potentiel $V_{PO}-V_T$ imposé sur $T_8$ au point P est légèrement supérieur au potentiel $V_{PO}-V_T$ sous la grille de $T_1$, l'excédent des charges est évacué par $T_1$.

L'arrivée des charges sous les électrodes de stockage négatives induit par influence une décroissance de potentiel $\Delta\phi_S-$ au point P, aussitôt compensée par le transistor $T_9$.

Le signal $\phi_C$ étant au niveau haut, le transistor $T_8$ conduit et charge la capacité de liaison $C_L$ à la valeur $V_{AO}-V_{CO}$.

— au temps $t_4$, le signal $\phi_C$ est revenu à zéro. Le potentiel du point $V_M$ reprend la valeur $V_{PO}-V_T$ (ligne 15 sur la figure 4d).

Le transistor $T_3$ est donc bloqué et le point A isolé demeure au potentiel $V_{AO}$ (ligne 18). Au temps $T_4$ également, le signal $\phi$ est au niveau haut et transfère les charges signal sous les électrodes de stockage entières. Le départ des charges des électrodes de stockage coupées négatives induit au point P une élévation de potentiel $\Delta\phi\bar{s}$ qui bloque $T_1$ et qui est telle que le potentiel au point P s'écrive:

$$V_P(t_4)=V_{PO}-V_T+\Delta\phi_S^-$$

avec

$$\Delta\phi_S^-=\frac{NG}{C_P}\sum_{k=1}^{N} Qe(t-kT)+\sum_{k=1}^{N} h_k^- \cdot \frac{Qe(t-kT)}{C_P} = \frac{Q^-}{C_P}$$

où N est le nombre de coefficients de pondération du filtre, G la largeur minimale du canal CCD définie précédemment, $Q_e(t)$ la charge injectée à l'entrée du filtre sous la grille d'échantillonnage $G_E$, T la période d'injection de charges dans le filtre, et $h_K^-$ les coefficients négatifs.

— au temps $t_5$ (voir figure 4e), le signal $\phi$ est au niveau bas et les charges signal sont transférées sous les électrodes de stockage positives. Cette arrivée des charges induit au point P un abaissement instantané de potentiel $\Delta\phi_S^+$ qui débloque le transistor $T_1$, si la somme des coefficients

$$\sum_{1}^{N}(h_K^+-h_K^-)$$

est positive. Le transistor $T_1$ étant de nouveau conducteur impose au point P la tension $V_{PO}-V_T$ et évacue sur le point A l'excédent de charges $(Q^+-Q^-)$ tel que;

$$Q^+-Q^-=C_P(\Delta\phi_S^+-\Delta\phi_S^-)$$

avec

$$\Delta\phi_S^+=\frac{NG}{C_P}\sum_{k=1}^{N} Q_e(t-kT)+\sum_{k=1}^{N} h_k^+ \cdot \frac{Q_e(t-kT)}{C_P} = \frac{Q^+}{C_P}$$

les $h_K^+$ étant les coefficients positifs.

D'où:

$$Q^+-Q^-= \sum_{k=1}^{N} (h_k^+-h_k^-) \cdot Q_e(t-kT)$$

L'arrivée de la quantité de charges $Q^+-Q^-$ au point A provoque un abaissement de poteniel $\Delta V_A$ égal à $V_A-V_{AO}$ qui représente les coefficients de pondération du filtre. Le potentiel au point A s'écrit:

$$V_A=V_{AO}-\frac{Q^+-Q^-}{C_A}$$

5

La capacité $C_L$ relié au point A conserve sa charge $C_L . (V_{AO}-V_{CO})$. Le potentiel du point C derrière la capacité $C_L$ subit le même abaissement que le point A. L'étage intermédiaire constitué par la capacité $C_L$ et le 'transistor $T_8$ entre les points A et C permet d'éviter que les suiveurs soient saturés par le potentiel élevé du transistor $T_3$.

Au temps $t_5$ également, le signal $\phi_L$ est au niveau haut. Le transistor $T_7$ est donc conducteur et prélève la variation de potentiel au point C qui sera maintenue sur la capacité $C_E$ jusqu'à la période d'injection des charges suivante.

Au temps $t_6$ (voir figure 4f), le signal $\phi$ est au niveau haut et les charges signal sont évacuées des électrodes de stockage positive. Le potentiel du point P subit par influence une élévation $\Delta\phi_S^+$ qui bloque à nouveau le transistor $T_1$.

En régime permanent, les instants $t_5$ et $t_6$ sont confondus avec les instants $t_1$ et $t_2$ pour lesquels l'injection des charges a été décrite. La quantité de charge $(Q^+-Q^-)$ transférée au point A au temps $t_5$ est donc évacuée au temps $t_3$ par le transistor $T_3$ qui décharge la capacité $C_M$, tandis que le point P retrouve la valeur $V_{PO}-V_T$. On suppose $C_M$ de valeur suffisamment grande pour que l'évacuation des charges affecte très peu le potentiel de pré-charge $V_{AO}$ de la capacité $C_A$. Le traitement d'un nouvel échantillon du signal d'entrée commence alors.

Dans un filtre CCD, la charge signal fonction du temps $(Q_S(t)$ est toujours superposée à une charge moyenne $Q_m$ constante:

$$Q_e(t)=Q_s(t)+Q_m$$

d'où

$$\Delta\phi_S^+-\Delta\phi_S^-=Q_m . \sum_1^N (h_k^+-h_k^-)+\sum_1^N (h_k^+-h_k^-) . Q_s(t-kT)$$

avec $|Q_S(t)|\ll Q_m$.

L'excursion en amplitude de $Q_s(t)$ étant toujours inférieure à celle de $Q_m$, le signe de $(\Delta\phi_S^+-\Delta\phi_S^-)$ est donc déterminé par celui de:

$$\sum_1^N (h_k^+-h_k^-)$$

Lorsque la somme des coefficients est négative, $\Delta\phi_S^+$ est donc inférieur à $\Delta\phi_S^-$ et l'arrivée des charges sous les électrodes de stockage positives n'est pas suffisante pour débloquer le transistor $T_1$ (voir figure 4e). Dans ce cas, on utilise la circuit 11 connecté au point P. Au temps $t_3$, le signal $\phi_C$ étant au niveau haut, la capacité $C_O$ stocke une charge $Q_O=C_O . V_O$. Au temps $t_5$, le signal $Q_L$ est au niveau haut et la quantité de charges $Q_O$ est transférée au point P par le transistor $T_6$. La charge $Q_O$ permet de débloquer $T_1$. La quantité de charges $Q_O+Q^+-Q^-$ est transférée au point A, cette quantité de charges doit être positive, ce qui s'obtient en ajustant le potentiel constant $V_O$ ou la capacité $C_O$.

Le filtre selon l'invention permet de supprimer la perturbation apportée à la lecture des charges se trouvant sous les électrodes de stockage par les signaux de commande, appliqués aux différentes électrodes, qui existent dans les filtres de l'art antérieur. Dans le filtre selon l'invention, le seul signal de commande appliqué aux électrodes est le signal $\phi$.

On désigne par $C_\phi$ la capacité de couplage, par recouvrement des électrodes commandées par les signaux $\phi$ et $V_p$.

Au temps $t_4$, le signal $\phi$ passe au niveau haut et induit par couplage une élévation de potentiel égale à:

$$\frac{C_\phi}{C_\phi+C_p} . V_\phi$$

qui s'ajoute à $\Delta\phi_S^-$.

Le potentiel du point P au temps $t_4$ s'écrit donc:

$$V_P(t_4)=V_{PO}-V_T+\frac{Q^-}{C_P}+\frac{C_\phi}{C_\phi+C_P} . V_\phi$$

Au temps $t_5$, le signal $\phi$ passe au niveau bas et induit au point P une décroissance de potentiel égale à:

$$-\frac{C_\phi}{C_\phi+C_P}$$

qui s'ajoute à $\Delta\phi_S^+$.

Le potentiel du point P au temps $t_5$ s'écrit donc:

$$V_P(t_5)=V_P(t_4)-(\frac{Q^+}{C_P} + \frac{C_\phi}{C_\phi+C_P} \cdot V_\phi)=V_{PO}-V_T- \frac{Q^+-Q^-}{C_P}$$

On peut donc constater que l'élaboration des coefficients de pondération du filtre se faisant en deux instants successifs, $t_4$ et $t_5$, avant et après le passage du signal $\phi$ au niveau haut, la quantité de charges $Q^T-Q^-$, qui est évacuée par le transistor $T_1$ afin que le point P reprenne la valeur $V_P=V_{PO}-V_T$ et qui correspond à l'élaboration d'un coefficient de pondération, est indépendante du couplage avec le signal $\phi$.

**Revendications**

1. Filtre transversal à transfert de charges électriques, comportant un substrat semi-conducteur recouvert d'une couche isolante sur laquelle alternent des électrodes de transfert et des électrodes de stockage des charges, caractérisé en ce que:

— une électrode de stockage (3) sur deux est coupée transversalement en deux parties dont l'une est connectié à un potentiel sensiblement constant $(V_P)$;
— des moyens de lecture (7), reliés en un point P à l'autre partie de chaque électrode de stockage coupée, lisent négativement les charges quittant une électrode de stockage coupée, dite négative, et positivement les charges arrivant sous l'électrode de stockage coupée suivante, dite positive;
— chaque coefficient de pondération est déterminé par l'utilisation de quatre électrodes de stockage alternativement coupées et non coupées, la différence de longueurs (G, $G+h_K$ . L) entre les parties des deux électrodes de stockage coupées sous lesquelles les charges sont lues, positivement et négativement, déterminant le coefficient.

2. Filtre selon la revendication 1, caractérisé en ce que les couples électrode de transfert-électrode de stockage coupée reçoivent ledit potentiel sensiblement constant $V_P$ et les couples électrode de transfert-électrode de stockage entière reçoivent une tension périodique, $(\phi)$, de période (T) égale à la moitié de la période d'injection des charges dans le filtre, qui assure, à un instant donné, la présence de charges sous une électrode de stockage coupée sur deux du filtre.

3. Filtre selon l'une des revendications 1 ou 2, caractérisé en ce que les moyens de lecture (7) comportent:

— un premier transistor $(T_1)$ qui est polarisé en saturation et dont la jonction drain source est connecteé entre le point P et une capacité de lecture $(C_A)$, qui est également connectée à la masse, ce transistor $(T_1$ rétablissant le potentiel $V_P$, au point P, après le départ des charges des électrodes de stockage coupées négatives et l'arrivée des charges sous les électrodes de stockage coupées positives, en assurant l'évacuation sous la capacité de lecture d'une quantité de charges $(Q^+-Q^-)$ correspondant aux coefficients de pondération du filtre;
— un deuxième transistor $(T_9)$ qui rétablit le potentiel $V_P$ au point P, après le départ des charges des électrodes de stockage coupées positives et l'arrivée des charges sous les électrodes de stockage coupées négatives;
— un troisième transistor MOS $(T_3)$, qui est relié au point commun du premier transistor $(T_1)$ et de la capacité de lecture $(C_A)$, et qui assure l'évacuation de la quantité de charges $(Q^+-Q^-)$ correspondant aux coefficients de pondération du filtre.

4. Filtre selon l'une des revendications 1 à 3, caractérisé en ce que, la somme des coefficients de pondération du filtre étant négative, les moyens de lecture (7) assurent l'injection d'une quantité de charges constante $(Q_O)$ sous le premier transistor $(T_1)$, après le départ des charges des électrodes de stockage coupées négatives, le redant ainsi conducteur lors de l'arrivée des charges sous les électrodes coupées positives.

**Patentansprüche**

1. Transversalfilter zum Uebertragen elektrischer Ladungen mit einer mit einer Isolierschicht bedeckten Halbleiterschicht, auf welcher abwechselnd Uebertragungselektroden und Ladungsspeicherelektroden angeordnet sind, dadurch gekennzeichnet dass:

— jede zweite Speicherelektrode (3) in Querrichtung in zwei Teile geteilt ist, wobei einer dieser Teile an ein wesentlich konstantes Potential $(V_P)$ angeschlossen ist;
— an den anderen Teil der geteilten Elektrode an einer Stelle P angeschlossene Lesenmittel (7) die von einer "negative Elektrode" genannten geteilten Speicherelektrode abgegebenen Ladungen negativ lesen und die unter der "positive Elektrode" genannten nächsten geteilten Speicherelektrode ankommenden Ladungen positiv lesen;
— jeder Abwägungskoeffizient durch die Verwendung vier abwechselnd angeordneten geteilter und nicht geteilter Speicherelektroden bestimmt, wobei der Unterschied zwischen den Längen (G, $G+h_K . L$) zwischen denjenigen Teilen der beiden geteilten Speicherelektroden, unter welchen die Ladungen positive und negativ gelesen werden, den Koeffizienten bestimmen.

2. Filter nach Anspruch 1, dadurch gekennzeichnet, dass die aus Uebertragungselektrode und geteilter Speicherelektrode bestehenden Elektrodenpaare das genannte wesentlich konstante Potential $V_P$ empfangen und die aus Uebertragungselektrode und nicht geteilter Speicherelektrode bestehenden Elektrodenpaare eine periodische Spannung mit einer Periode empfängt, die der halben Periode des Eingebens der Ladungen in den Filter entspricht, wobei diese periodische Spannung zu einem gegebenen Zeitpunkt die Anwesenheit von Ladungen unter jeweils einer von zwei geteilten Speicherelektroden des Filters sichert.

3. Filter nach Anspruch 1 oder 2, dadurch gekennzeichnet, dass die Lesemittel (7) umfassen:
— einen ersten polarisationsgesättigten Transistor ($T_1$), dessen Dränieranschluss zwischen dem Punkt P und einem Lesekondensator ($C_A$) leigt, welcher ferner geerdet ist, wobei dieser Transistor ($T_1$) das Potential am Punkt P nach der Abgabe der Ladungen der geteilten negativen Elektroden und nach der Ankunft der Ladungen unter den geteilten positive Elektroden wiederherstellt, indem die Ableitung einer den Abwägungskoeffizienten des Filters entsprechenden Menge von Ladungen ($Q^+ - Q^-$) unter dem Lesekondensator sichert;
— einen zweiten Transistor ($T_9$), der das Potential am Punkt P nach dem Ableiten der Ladungen der geteilten positiven Speicherelektroden und nach der Ankunft der Ladungen unter den geteilten negativen Speicherelektroden wiederherstellt;
— einen dritten MOS-Transistor ($T_3$), der an gemeinsamen Punkt des ersten Transistors ($T_1$) und des Lesekondensators ($C_A$) angeschlossen ist und die Ableitung der den Abwägungskoeffizienten des Filters entprechenden Mengen von Ladungen ($Q^+ - Q^-$) sichert.

4. Filter nach einem der Ansprüche 1 bis 3, dadurch gekennzeichnet, dass wenn die Summe der Abwägungskoeffizient des Filters negativ ist, die Lesemittel (7) die Einleitung einer konstanten Ladungsmenge ($Q_0$) unter den ersten Transistor ($T_1$) nachdem die Ableitung der Ladungen der geteilten negativen Speicherelektroden erfolgt ist, wodurch dieser Transistor aufgrund der Ankunft der Ladungen unter den geteilten positiven Elektroden leitfähig wird.

**Claims**

1. An electric charge-transfer transversal filter, comprising a semiconductive substrate covered with an insulating layer, on which charge-transfer and charge-storage electrodes alternate, characterized by the fact that:
— one storage electrode (3) in every two is divided transversely into two parts, one of which is connected to a substantially constant potential ($V_P$);
— a reading device (7) connected at point P to the other part of each divided storage electrode reads negatively the charges leaving a divided storage electrode, referred to as "negative", and reads positively the charges arriving under the following divided storage electrode, referred to as "positive";
— each weighting coefficient is determined by the use of four storage electrodes, alternately divided and not divided, the difference in lengths (G, $G+h_K . L$) between the parts of the two divided storage electrodes beneath which charges are read, positively and negatively, determining the coefficient.

2. A filter as defined in Claim 1, characterized by the fact that the transfer electrode/divided storage electrode pairs receive the approximately constant potential $V_P$, and the transfer electrode/whole storage electrode pairs receive a periodical voltage ($\phi$), the period (T) of which is equal to half the period of charge injection into the filter, which ensures, at any given time, the presence of charges beneath one divided storage electrode in every two in the filter.

3. A filter as defined in either of Claims 1 and 2, characterized by the fact that the reading device (7) comprises:

— a first transistor ($T_1$), saturation polarized, and the drain/source junction of which is connected between the point P and a reading capacitor ($C_A$), which is also connected to earth, this transistor ($T_1$) re-establishing the potential $V_P$ at point P, after the departure of charges from the negative divided storage electrodes and the arrival of charges beneath the positive divided storage electrodes, providing removal beneath the reading capacitor of a quantity of charges ($Q^+ - Q^-$) corresponding to the filter weighting coefficients;

— a second transistor ($T_9$), which re-establishes the potential $V_p$ at point P, after the departure of charges from the positive divided storage electrodes, and the arrival of charges beneath the negative divided storage electrodes;

— a third MOS transistor ($T_3$), which is connected to the common point of the first transistor ($T_1$) and of the reading capacitor ($C_A$), and which removes the quantity of charges ($Q^+ - Q^-$) corresponding to the filter weighting coefficients.

4. A filter as defined in any one or other of Claims 1 to 3, characterized by the fact that, the sum of the filter weighting coefficients being negative, the reading device (7) injects a constant quantity of charges ($Q_0$) beneath the first transistor ($T_1$), after the departure of the charges from the negative divided storage electrodes, thereby rendering it conductive when the charges arrive beneath the positive divided electrodes.

0017541

# FIG_1

# FIG_3

## FIG_3-a

## FIG_3-b

## FIG_3-c

1

FIG_2

# FIG_4

## FIG_4-a

## FIG_4-b

$(t_1, t_2)$

## FIG_4-c

$(t_3)$

## FIG_4-d

$(t_4)$

## FIG_4-e

$(t_5)$

## FIG_4-f

$(t_6)$